# EUROPEAN PATENT APPLICATION

(11) **EP 4 561 296 A2**
(43) Date of publication of application: **28.05.2025**
(21) Application number: 24211343.9
(22) Date of filing: 07.11.2024
(51) Int. Cl.: H10D 62/10, H10D 30/01, H10D 30/00, H10D 84/01, H10D 84/85, H10D 88/00

(54) **COMPLEMENTARY FET DEVICE AND CONTROL METHOD THEREOF**

(30) Priority: 21.11.2023 KR 20230162440; 08.08.2024 KR 20240106019
(71) Applicant: Electronics and Telecommunications Research Institute, Daejeon 34129 (KR)
(72) Inventor: Kim, Sang Hoon, 34129 Daejeon (KR); Suh, Dongwoo, 34129 Daejeon (KR); Park, Jeong Woo, 34129 Daejeon (KR); Sohn, Minkyun, 34129 Daejeon (KR); Lee, Seong Hyun, 34129 Daejeon (KR); Lee, Wangjoo, 34129 Daejeon (KR); Kim, Jinha, 34129 Daejeon (KR); Park, Min-A, 34129 Daejeon (KR); Jung, Sun Kyu, 34129 Daejeon (KR); Heo, Subin, 34129 Daejeon (KR)
(74) Representative: Betten & Resch

(57) **Abstract**

Provided is a transistor device including: a substrate; a lower transistor positioned on the substrate and including a lower channel layer, a lower gate, and a lower source/drain region; an upper transistor positioned on the lower transistor and including an upper channel layer, an upper gate, and an upper source/drain region; and an inner spacer configured to insulate the lower transistor from the upper transistor, wherein the inner spacer may be formed by removing a portion of each of a first sacrificial layer and a second sacrificial layer, which are formed above and below the lower channel layer and the upper channel layer and have different Ge contents, to a depth according to a Ge content and then depositing an insulating material.

## Description

### CROSS-REFERENCE TO RELATED APPLICATION

This application claims priority to and the benefit of Korean Patent Applications 10-2023-0162440, filed on Nov 21, 2023 and No. 10-2024-0106019, filed on Aug 8, 2024 and the disclosure of which is incorporated herein by reference in its entirety.

### BACKGROUND

### 1. Field of the Invention

Various embodiments of the present disclosure relate to a semiconductor manufacturing technology.

### 2. Discussion of Related Art

As electronic devices are miniaturized and are more highly integrated, semiconductor devices mounted on the electronic devices are also becoming more integrated and ultra-fine. Since field effect transistors (FETs) are disposed horizontally on a wafer substrate in the conventional FET with a gate all around (GAA) structure, the number of applicable transistors per unit area of the wafer substrate is limited.

In order to address the problem, a complementary-FET (CFET) with vertically stacked n-metal oxide semiconductor FET (MOSFET) and p-MOSFET of GAA structures have recently been proposed.

### SUMMARY OF THE INVENTION

However, since a CFET device is still just an idea technology, a detailed manufacturing process is not disclosed yet.

The present disclosure is directed to providing a complementary transistor device and a control method thereof, which may form an inner spacer using sacrificial layers with different Ge contents.

According to an aspect of the present disclosure, there is provided a transistor device including a substrate, a lower transistor positioned on the substrate and including a lower channel layer, a lower gate, and a lower source/drain region, an upper transistor positioned on the lower transistor and including an upper channel layer, an upper gate, and an upper source/drain region, and an inner spacer formed by removing a portion of each of a first sacrificial layer and a second sacrificial layer, which are formed above and below the lower channel layer and the upper channel layer and have different Ge contents, to a depth according to a Ge content and then depositing an insulating material.

According to another aspect of the present disclosure, there is provided a method of manufacturing a transistor device, which includes forming a nanosheet stack including a lower channel layer, an upper channel layer, and a plurality of first and second sacrificial layers separating the lower channel layer from the upper channel layer, wherein the first and second sacrificial layers have different Ge contents, forming an inner spacer in a space provided by removing a portion of the first sacrificial layer and a portion of the second sacrificial layer through an etching process at a rate according to a Ge content, and forming a lower gate around the lower channel layer and an upper gate around the upper channel layer in a provided space from which the remaining portion of each of the first and second sacrificial layers is removed.

According to still another aspect of the present disclosure, there is provided a transistor device including a nanosheet stack including a lower channel layer, an upper channel layer, and a plurality of first and second sacrificial layers separating the lower channel layer from the upper channel layer, an inner spacer formed on some side surfaces of the first and second sacrificial layers between at least the lower channel layer and the upper channel layer, a lower gate formed around the lower channel layer in a space remaining after removing the first and second sacrificial layers, and an upper gate formed around the upper channel layer, wherein the first and second sacrificial layers have different Ge contents, and the inner spacer is formed by removing a portion of the first sacrificial layer and a portion of the second sacrificial layer through an etching process at a rate according to a Ge content.

### BRIEF DESCRIPTION OF THE DRAWINGS

The above and other objects, features and advantages of the present disclosure will become more apparent to those of ordinary skill in the art by describing exemplary embodiments thereof in detail with reference to the accompanying drawings, in which:
FIGS. 1 and 2 are diagrams illustrating a process of forming a nanosheet stack of a semiconductor device according to one embodiment;
FIGS. 3 to 7 are diagrams illustrating a process of forming a shallow trench isolation (STI) module of the semiconductor device according to one embodiment;
FIGS. 8 to 15 are diagrams illustrating a process of forming a dummy gate module of the semiconductor device according to one embodiment;
FIGS. 16 to 21 are diagrams illustrating a process of forming an inner spacer module of the semiconductor device according to one embodiment;
FIG. 22 is a diagram for describing an epitaxial growth process of forming lower source/drain according to one embodiment;
FIGS. 23 to 28 are diagrams illustrating a process of forming and separating an n-metal oxide semiconductor field effect transistor (MOSFET) device and a p-MOSFET device;
FIGS. 29 to 44 are diagrams for describing a process of forming a replacement metal gate (RMG);
FIGS. 45 to 51 are diagrams for describing a process of forming a metal line;
FIG. 52 is a diagram illustrating a structure of a complementary transistor device according to one embodiment; and
FIG. 53 is a flowchart illustrating a method of manufacturing a complementary transistor device according to one embodiment.

In the description of the drawings, the same or similar reference numerals may be used for the same or similar components.

### DETAILED DESCRIPTION OF EXEMPLARY EMBODIMENTS

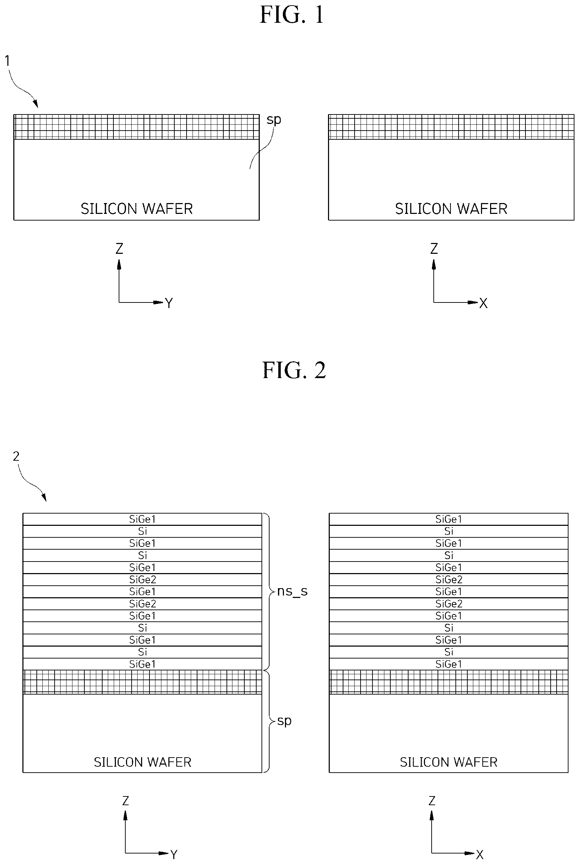

FIGS. 1 and 2 are diagrams illustrating a process of forming a nanosheet stack of a semiconductor device according to one embodiment.

Referring to FIG. 1, a lower isolation layer may be formed on a semiconductor substrate sp.

The semiconductor substrate sp may include a silicon substrate and a Si-on-insulator (SOI) substrate. The semiconductor substrate sp may include a p-type, n-type, or intrinsic silicon substrate.

The lower isolation layer may be formed by forming an insulating material on the semiconductor substrate sp or through performing appropriate ground plane doping on the semiconductor substrate sp. The lower isolation layer of the semiconductor substrate sp may act to reduce a leakage current in an off-state of a channel formed in the semiconductor substrate sp.

In the lower isolation layer, a metal gate may be formed around a Si channel layer after selective etching of a SiGe sacrificial layer in a replacement metal gate (RMG) module. Then, the metal gate of the lower isolation layer is in contact with the semiconductor substrate sp, and source/drain are formed below the lower isolation layer, and thus the lower isolation layer has a structure in the form of a planar field effect transistor (FET).

As shown in FIG. 2, a nanosheet stack ns_s may be formed by repeatedly and continuously growing Si epitaxial layers Si and SiGe epitaxial layers (at least one of a first sacrificial layers and a plurality of a second sacrificial layers) SiGe1 and SiGe2 on the semiconductor substrate sp. In this regard, the Si epitaxial layer may constitute channel layers of stacked-type n-metal oxide semiconductor FET (MOSFET) and p-MOSFET devices with a complementary FET (CFET) structure. Both the first sacrificial layer SiGel and the second sacrificial layer SiGe2 may be sacrificial layers fully removed by selective etching in a subsequent process. The first sacrificial layer SiGe1 may be formed on an upper portion and a lower portion of each of at least a lower channel layer l_ch and an upper channel layer u_ch. The second sacrificial layer SiGe2 may be formed between the first sacrificial layers SiGe1 present between the at least lower channel layer l_ch and the upper channel layer u_ch.

An example in which two channel layers Si are formed in each of the n-MOSFET and p-MOSFET are shown in FIG. 2. However, the present disclosure is not limited thereto. For example, the number of channel layers Si may be one or three or more, and the number of Si channels may be determined through repeated growth of the SiGe epitaxial layer and the Si epitaxial layer. Similarly, the number and type of the sacrificial layers SiGe1 and SiCe2 is not limited thereto. For example, at least one type of the sacrificial layers is further included. As another example, the number of the first and the second sacrificial layers may be different from the FIG. 2.

Since a lattice constant difference of approximately 4.3% between Si and Ge, stress may occur in the thin film during the repeated growth of the SiGe epitaxial layer and the Si epitaxial layer. When a thickness of the thin film exceeds a critical thickness in a state in which stress occurs, the stress is reduced by releasing accumulated stress energy. Then, dislocations are generated at an interface, which may degrade performance of the device and cause a leakage current.

In order to prevent the dislocations, the Si epitaxial layer Si and the SiGe epitaxial layers SiGe1 and SiGe2 may be grown by at least one low-vacuum process among remote plasma chemical vapor deposition (RPCVD), ultra-high vacuum chemical vapor deposition (UHVCVD), molecular beam epitaxy (MBE), and atomic layer deposition (ALD) growth methods. Therefore, crystallinity of the channel layer may be secured and a composition and a thickness may be precisely controlled.

The Si epitaxial layer Si (channel layer) may be formed to have a thickness of 5 nm to 30 nm. The SiGe epitaxial layers SiGe1 and SiGe2 (sacrificial layers) may each be formed to have a thickness of 5 nm to 30 nm. The SiGe epitaxial layer SiGe1 located at the top may be formed to be thicker than the other layers in consideration of thickness reduction due to subsequent processes. For example, the SiGe epitaxial layer SiGe1 located at the top may be formed to have a thickness of 5 nm to 100 nm.

According to one embodiment, the epitaxial layers may be formed so as to prevent an empty space from being formed during the formation of an inner spacer in a subsequent process. For example, epitaxial growth may be performed at a Ge content of 10% to 30% of the SiGe epitaxial layer SiGe1. Epitaxial growth may be performed at a ratio of a Ge content of the SiGe epitaxial layer SiGe2 that is at least 20% greater than that of the SiGe epitaxial layer SiGe1. Specifically, the first sacrificial layers SiGe1 may be a SiGe layer having a Ge content of 10% to 30%. The second sacrificial layer SiGe2 may be a SiGe layer having a Ge content that is at least 20% greater than that of the first sacrificial layer.

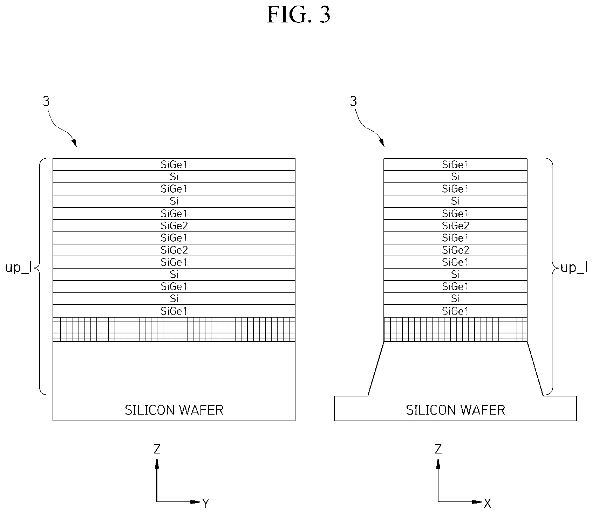

FIGS. 3 to 7 are diagrams illustrating a process of forming a shallow trench isolation (STI) module of the semiconductor device according to one embodiment.

As shown in FIG. 3, an upper portion up_l, including the nanosheet stack ns_s and a portion of the semiconductor substrate sp, is etched in a protruding shape using, for example, a hard mask. The upper portion up_l process is a process of forming a trench isolation for separation between devices and may be identical or similar to a process of forming a fin of a fin-FET.

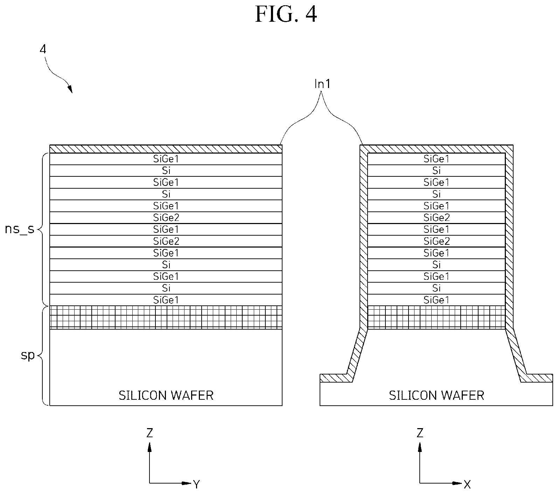

As shown in FIG. 4, a silicon nitride layer (SiₓN_{y}) liner layer ln1 is formed on the upper portion up_l by a deposition method such as LPCVD, PECVD, or ALD. The liner layer ln1 may be formed to have a thickness of 30 nm or less. The liner layer ln1 may prevent oxidation of the Si epitaxial layer and the SiGe epitaxial layers SiGe1 and SiGe2 and diffusion of Ge during a subsequent process of forming a trench isolation.

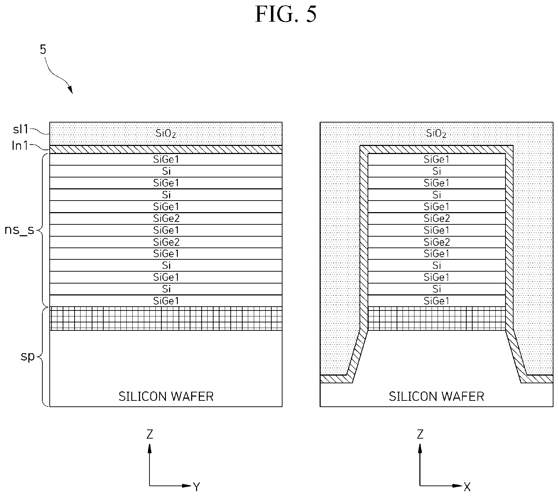

As shown in FIG. 5, a silicon oxide layer sl1 is grown on the entire surface of a semiconductor substrate 4 of FIG. 4, and thus an etched region in FIG. 3 is filled with the silicon oxide layer sl1. Then, a portion of the silicon oxide layer sl1 is planarized by a chemical mechanical polishing (CMP) process. Here, the silicon oxide layer sl1 may be densified through a high- heat treatment process before the process of planarizing the silicon oxide layer sl1. Since the heat treatment process is performed at a temperature of 900 °C or less, Ge diffusion from the SiGe layer to the Si channel layer can be prevented. In this case, the silicon nitride layer liner layer ln1 may be used as an etch stop layer in the planarization process of the silicon oxide layer sl1. Alternatively, the planarization process may be performed before the silicon nitride layer liner layer ln1 is exposed.

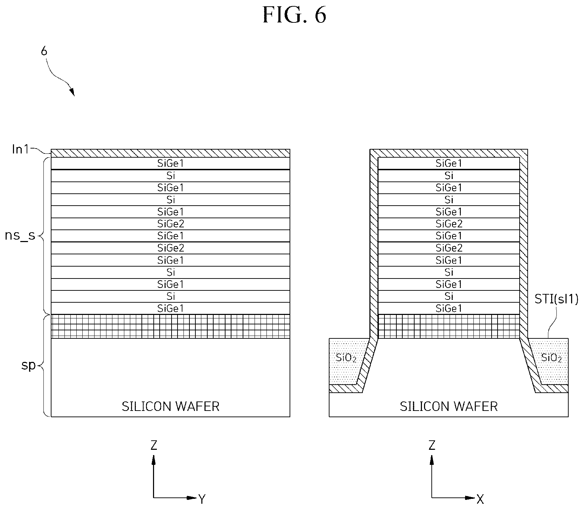

As shown in FIG. 6, a portion of the silicon oxide layer sl1 may be etched by an etch-back process. In this case, the etch-back process may be performed to a depth at which the silicon nitride layer liner layer ln1 is not etched. In this regard, the etch-back process may be performed using a process with higher etch selectivity for the silicon oxide film sl1 than for silicon nitride layer (SiₓN_{y}). In this case, an STI module STI corresponding to the remaining silicon oxide layer sl1 may be provided lower than starting heights of the Si epitaxial layer and the SiGe epitaxial layers SiGe1 and SiGe2. Accordingly, the Si epitaxial layer and the SiGe epitaxial layers SiGe1 and SiGe2 may all be exposed in subsequent processes.

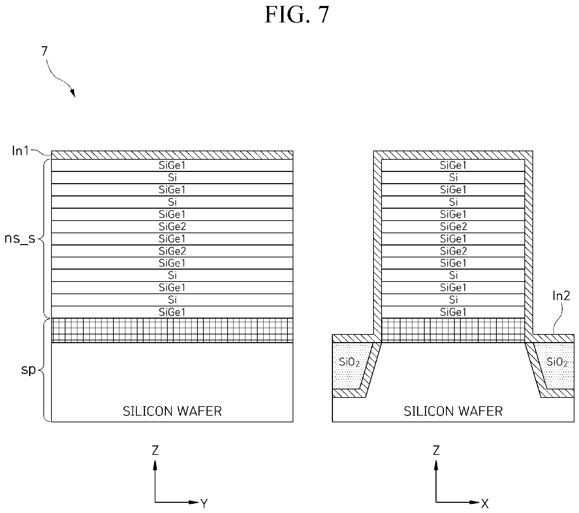

As shown in FIG. 7, a silicon nitride layer liner layer ln2 may be grown on the STI module STI to a thickness of 30 nm or less. In this case, the liner layer ln1 etched together with the silicon oxide layer sl1 in FIG. 6 may also be re-grown. Hereinafter, an example of a case in which the process in FIG. 7 is not performed will be described. However, the present disclosure is not limited thereto.

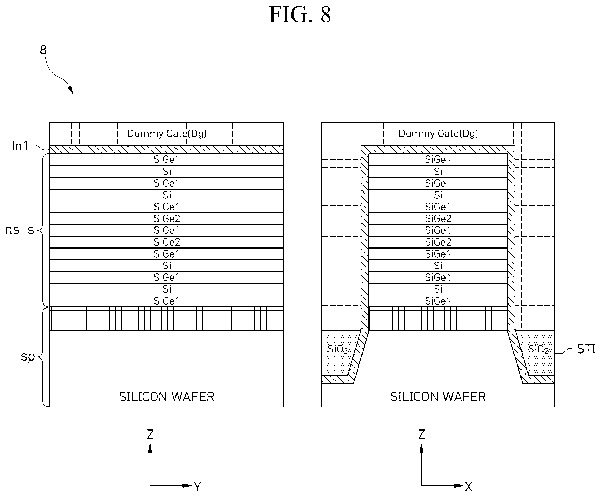

FIGS. 8 to 15 are diagrams illustrating a process of forming a dummy gate module of the semiconductor device according to one embodiment.

As shown in FIG. 8, a dummy gate Dg may be grown on the entire upper surface of the semiconductor substrate sp. Thereafter, the dummy gate Dg is planarized by a CMP process. The dummy gate Dg may be formed using polycrystalline Si or SiGe, or amorphous Si or SiGe. Alternatively, the dummy gate Dg may be formed using another material with high etch selectivity with respect to a silicon nitride ( protection ) layer ln1 and ln2. Here, a planarization process of the dummy gate Dg may be performed so as not to expose the liner layers ln1 and ln2. The dummy gate Dg remaining after the planarization may be a region where a high-k insulating film and a gate metal are deposited through a subsequent process to form a gate stack.

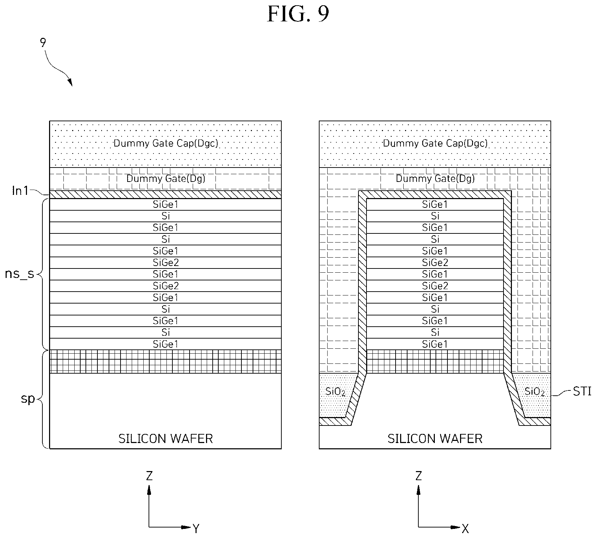

As shown in FIG. 9, a dummy gate cap Dgc may be deposited on the planarized dummy gate Dg using a silicon nitride layer. The dummy gate cap Dgc may be used as a hard mask during etching of the channel layer Si.

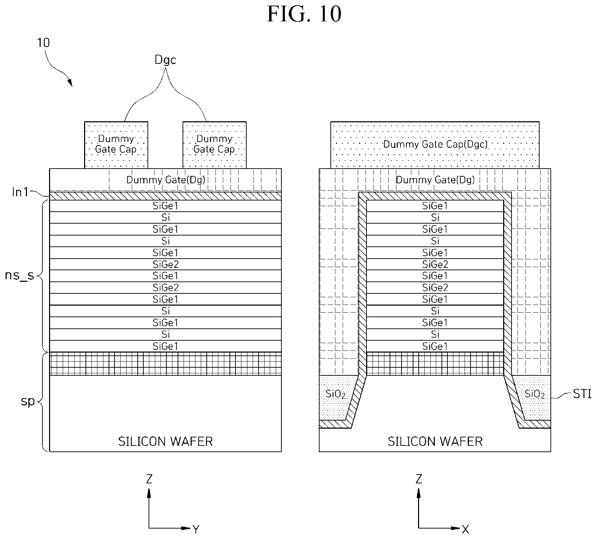

Referring to FIG. 10, the dummy gate cap Dgc that is the silicon nitride layer is patterned through, for example, a dry etching process. The etching process may be performed by photolithography and a dry etching process according to, for example, a silicon channel length (or gate width of a region where the source/drain are to be formed) of the semiconductor device according to one embodiment.

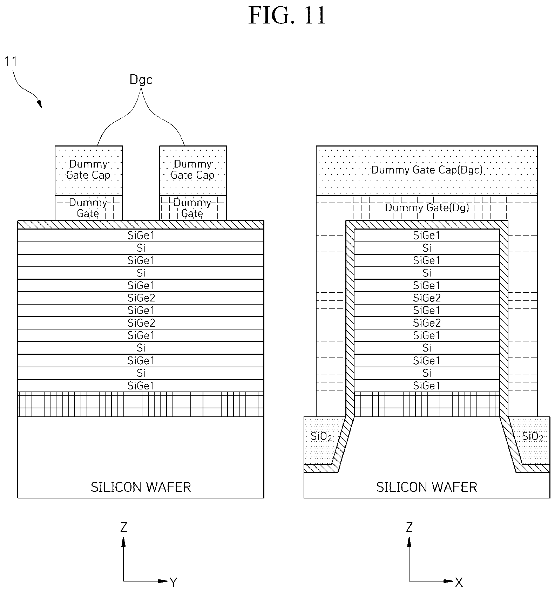

Referring to FIG. 11, the dummy gate cap Dgc is used as a hard mask to etch the dummy gate Dg according to the silicon channel length of the semiconductor device according to one embodiment.

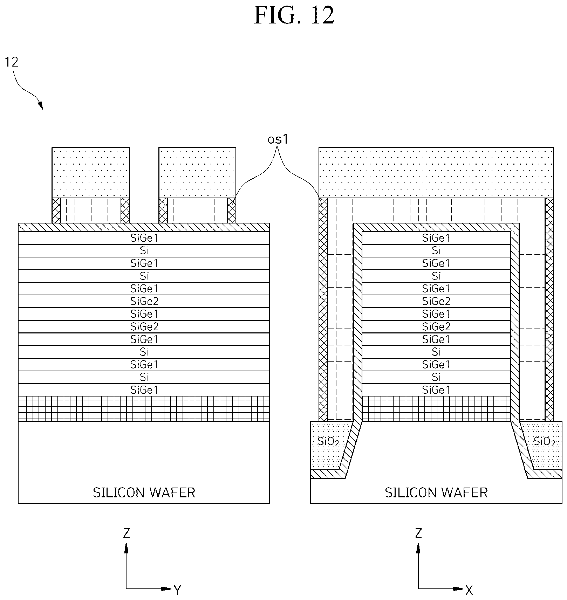

Hereinafter, a process of forming an outer spacer on a side surface of the dummy gate Dg will be described with reference to FIGS. 12 to 15.

As shown in FIG. 12, an outer spacer os1 is formed on the side surface of the dummy gate Dg. The outer spacer os1 is formed as a silicon oxide layer when a thermal oxidation process is performed at a temperature of 900 °C or less. During the thermal oxidation process, since the silicon oxide layer is grown simultaneously from an initial boundary surface in a direction away from a horizontal center of the semiconductor substrate sp, a thickness of the outer spacer os1 may be formed in consideration of a width of the channel layer.

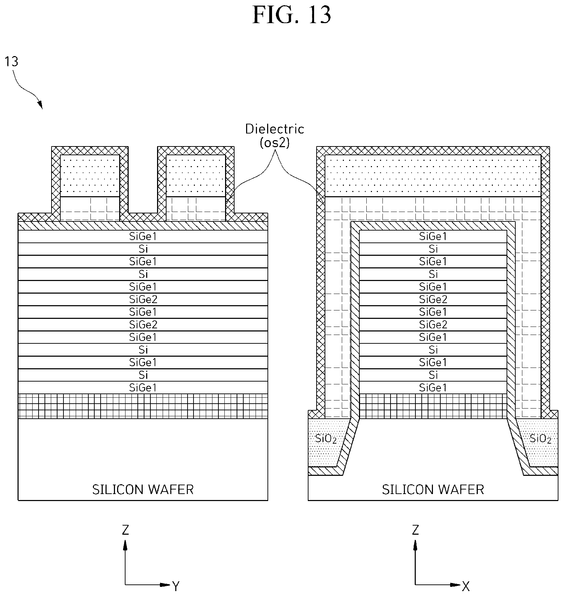

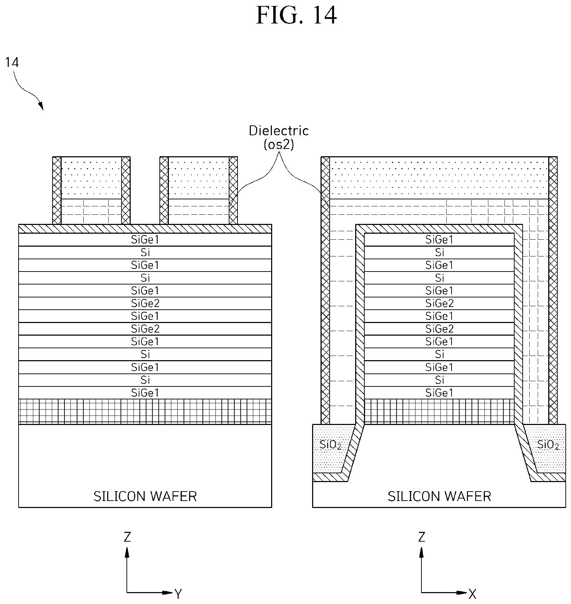

Alternatively, as shown in FIGS. 13 and 14, an outer spacer os2 may be formed by a process different from that of FIG. 12. As shown in FIG. 13, the outer spacer os2 may be formed by growing a specified material on the entire surface of the wafer using ALD or CVD. The specified material may include at least one material among a silicon oxide layer, a silicon nitride layer, or silicon carbide such as SiN, SiO, SiC, SiCO, and SiCN. Additionally, as shown in FIG. 14, since the upper portion of the grown outer spacer layer os2 is etched by an anisotropic etching process, the outer spacer os2 may left only side surfaces of the upper portions of the dummy gate Dg and the dummy gate cap Dgc. Hereinafter, an example in which the outer spacer os1 of FIG. 12 is applied will be described. However, the present disclosure is not limited thereto.

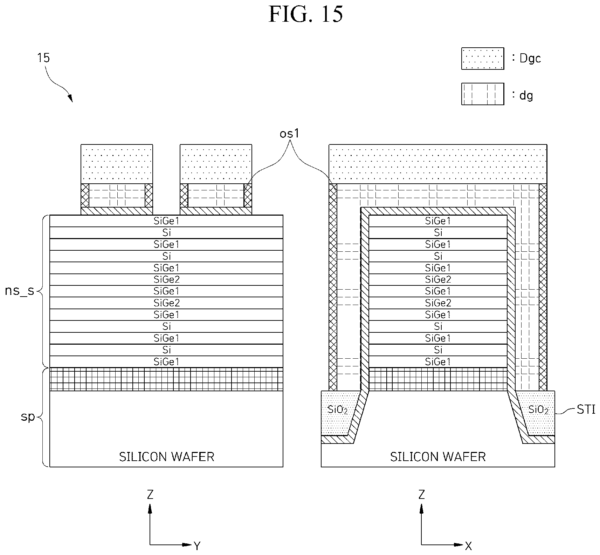

As shown in FIG. 15, wet or dry etching on the silicon nitride layer ln2 is selectively performed on the silicon nitride layer ln2 using a process with higher etch selectivity for the silicon nitride layer ln2 than for the silicon oxide layer os1. As the silicon nitride layer In2 is etched, the upper portion of the SiGe sacrificial layer SiGe1 may be exposed. In this case, the dummy gate cap Dgc is also etched simultaneously with the silicon nitride layer, but the process is controlled so as not to completely remove the dummy gate cap Dgc.

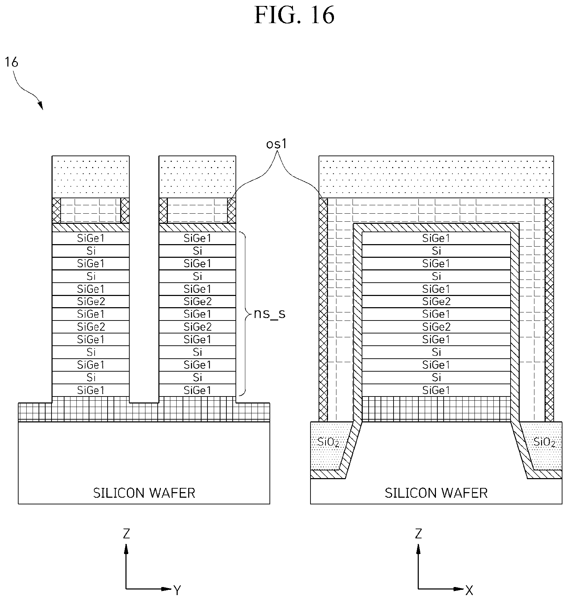

Hereinafter, a process of forming an inner spacer module of the semiconductor device according to one embodiment will be described with reference to FIGS. 16 to 21.

As shown in FIG. 16, the dummy gate cap Dgc that is a silicon nitride layer and the outer spacer os1 are used as hard masks to etch the Si channel layer Si and some of the first sacrificial layer SiGe1 and the second sacrificial layers SiGe2. In FIG. 16, by using a process with high etch selectivity with respect to the silicon oxide layer and the silicon nitride layer, the process may be controlled to selectively etch only the Si channel layer Si, the first sacrificial layer SiGe1, and the second sacrificial layer SiGe2. In FIG. 16, an etch may be progressed to a depth where the nanosheet stack ep including the Si channel layer Si and the first and second sacrificial layers SiGe1 and SiGe2 are all exposed, and the trench isolation TI is exposed.

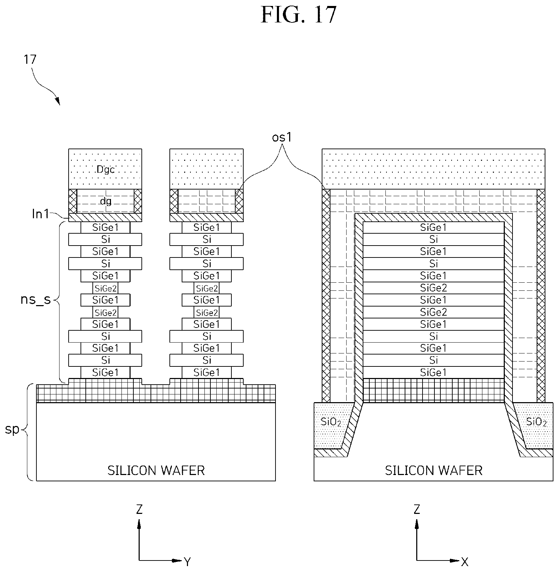

In a structure in which the Si channel layer Si and the first and second sacrificial layers SiGe1 and SiGe2 are exposed as shown in FIG. 16, a cavity etching process of the first and second sacrificial layers SiGe1 and SiGe2 to form an inner spacer is1 is performed as shown in FIG. 17.

In the cavity etching process, the first and second sacrificial layers SiGe1 and SiGe2 are not completely etched, but the first and second sacrificial layers SiGe1 and SiGe2 may be selectively wet or dry etched as much as a width of the inner spacer. The inner spacer is1 determines a length of the Si channel and serves as a self-alignment mask during the source/drain formation, and thus uniformity is essential.

The cavity etching process of the first and second sacrificial layers SiGe1 and SiGe2 should have a very high selectivity with respect to the dummy gate cap Dgc, the outer spacer os1, and the Si channel layer Si, and an etch rate should increase according to the Ge contents in the first and second sacrificial layers SiGe1 and SiGe2.

In this way, an etch depth of the second sacrificial layer SiGe2, which has the Ge content that is at least 20% higher than that of the first sacrificial layer SiGe1, should be greater than that of the first sacrificial layer SiGe1 through the etching process.

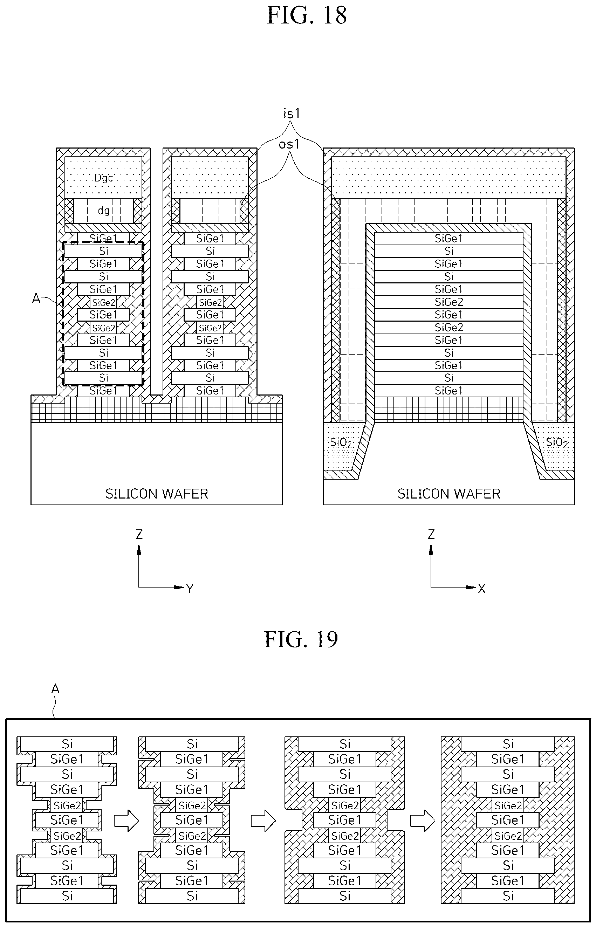

As shown in FIG. 18, the inner spacer is1 is deposited on the entire surface, where the SiGe cavity etching process is performed, using ALD. The inner spacer is1 may be formed using a specified material. The specified material may include at least one material among a silicon oxide layer, a silicon nitride layer, or silicon carbide such as SiN, SiO, SiC, SiCO, and SiCN.

As shown in FIG. 19, when the specified material is formed on the remaining side surfaces of each of the first and second sacrificial layers SiGe1 and SiGe2 of FIG. 16 using ALD, a outside side surface of the inner spacer is1 may be gradually flat.

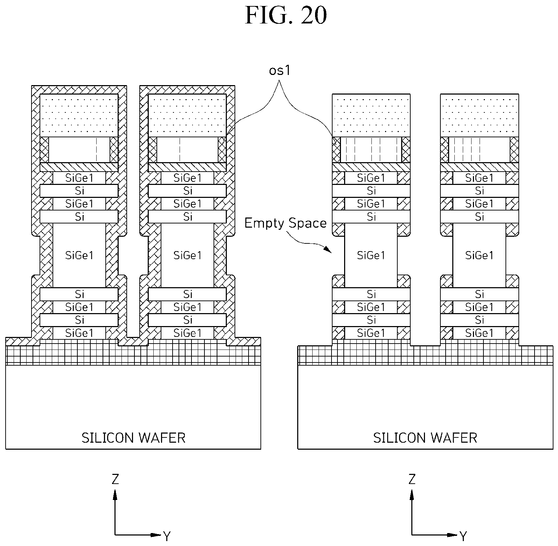

FIG. 20 shows a deposition result of a specified material when only the first sacrificial layer SiGe1 is used according to another embodiment.

Referring to FIG. 20, unlike one embodiment, when only the SiGe sacrificial layer SiGe1 with the same Ge content is used, it can be seen that no insulating material is deposited on some side surface of the first sacrificial layer SiGe1. In this case, a gap between the n-MOSFET and the p-MOSFET, which are to be vertically stacked in a subsequent process is not electrically insulated, a CFET structure cannot be formed. Specifically, in the left case of FIG. 20, a thickness of the inner spacer formed on the side surface of the first sacrificial layer SiGe1 between upper and lower Si channel layers and a thickness of the inner spacer formed on the side surface of the Si channel layer are the same or similar. Thus, since the etching is performed at the same thickness during the etching of the formed inner spacers, empty space may be generated in the inner spacers. Consequently, a problem in that the source/drain are formed in an unnecessary portion during a subsequent source/drain epitaxial growth may occur.

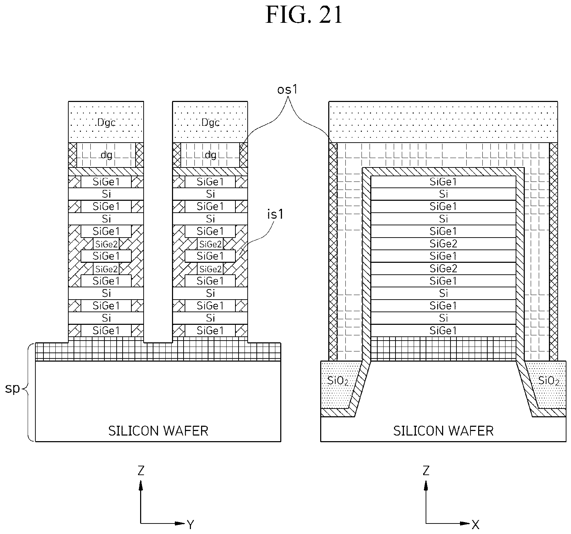

FIG. 21 is a diagram for describing the inner spacer of the semiconductor device.

Referring to FIG. 21, a portion of an inner spacer material deposited on the semiconductor substrate sp is removed through an etching process. In the etching process, the inner spacer materials deposited on the side surface of the Si channel layer Si and on the top and side surfaces of the dummy gate Dg and the dummy gate cap Dgc are etched. The inner spacer material is deposited to be thicker on the first and second sacrificial layers SiGe1 and SiGe2 than on the Si channel layer Si. In the etching process, the etching of the inner spacer is1 may be controlled to expose only the side surface of the Si channel layer Si. The etching process may be performed, for example, by a wet or dry etching process or an atomic layer etch (ALE) process. The inner spacer material remaining through the above-described etching process may form the inner spacer is1 as shown in FIG. 21.

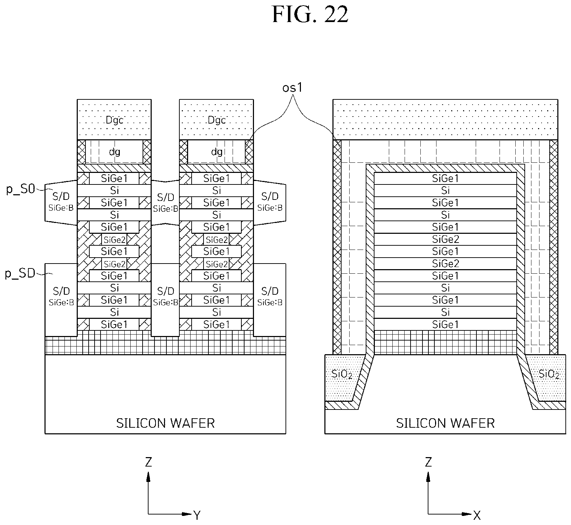

Hereinafter, a process of forming sources/drains of the n-MOSFET and the p-MOSFET will be described with reference to FIG. 22.

FIG. 22 is a diagram for describing an epitaxial growth process of forming lower source/drain according to one embodiment.

Referring to FIG. 22, selective epitaxial growth of source/drain regions p_S0 and p_SD is performed using the Si channel layer Si, where silicon is exposed, and the lower isolation layer of the silicon substrate sp as seed layers. The selective epitaxial growth does not proceed on the silicon oxide layer (e.g., the inner spacer is1) but only on the exposed silicon portion. A lower p-MOSFET of a CFET device according to one embodiment is formed. To this end, a SiGe epitaxial layer doped with a p-type dopant in real-time may be selectively grown. Alternatively, after the SiGe epitaxial layer is selectively grown, doping may be performed through an ion implantation process of a p-type dopant. In this case, a Ge content in each of the source/drain regions p_S0 and p_SD may be 20% or more.

In FIG. 22, it can be seen that an unnecessary p-type dummy source/drain region is formed in the upper Si channel layer together with the p-type source/drain region p_SD in the lower p-MOSFET. However, due to the structure of the designed CFET device, the dummy source/drain p_S0 on an upper portion is removed through a subsequent process.

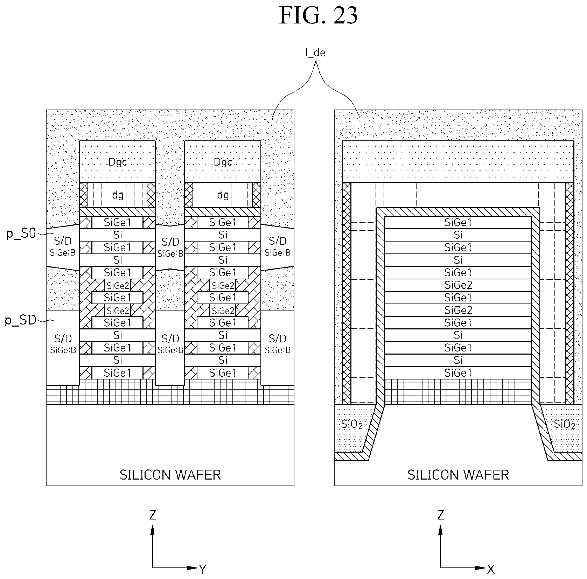

Hereinafter, a process of forming and separating the n-MOSFET device and the p-MOSFET device will be described with reference to FIGS. 23 to 28.

FIG. 23 is a diagram illustrating a process of covering a semiconductor substrate with an insulator (organic solvent) according to one embodiment.

Referring to FIG. 23, an organic solvent l_de is formed to a height that is greater than that covering the dummy gate over the semiconductor substrate. The organic solvent l_de is an organic solvent for a semiconductor and may include, for example, propylene glycol methyl ether acetate (PGMEA), propylene glycol propyl ether (PGPE), cyclohexanone, ethyl lactate (EL), γ-butyrolactone (GBL), or N-methylpyridine (NMP). The organic solvent may be used in photo resist (PR), bottom anti-reflective coating (BARC), or spin-on carbon (SoC).

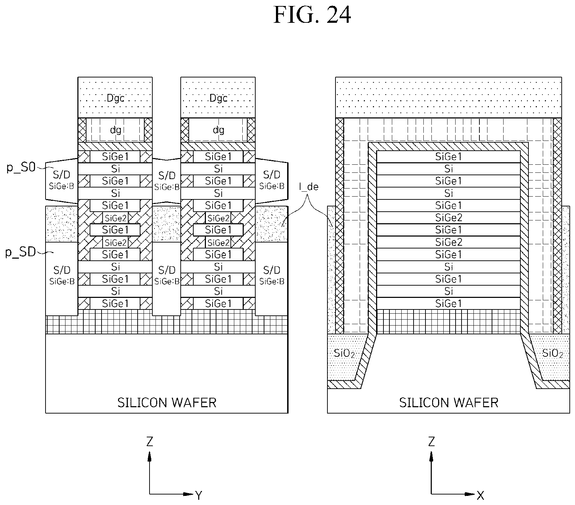

FIG. 24 shows an etch-back process of the organic solvent l_de for a semiconductor.

As shown in FIG. 24, some of the organic solvent l_de for a semiconductor may be removed through an etch-back process. As a result, the source/drain region p_S0 formed in the upper n-MOSFET may be completely exposed, and the source/drain region p_SD formed in the lower p-MOSFET may be formed in a form covered with the organic solvent l_de for a semiconductor.

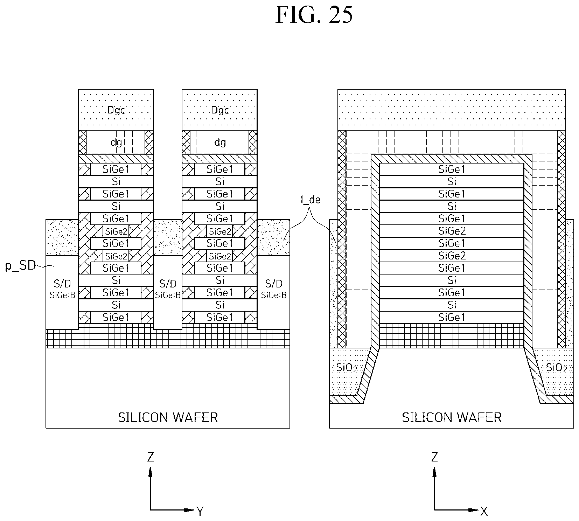

FIG. 25 is a diagram for describing an etching process of the upper source/drain SiGe epitaxial layer.

As shown in FIG. 25, the dummy source/drain region p_S0 formed in the upper n-MOSFET is selectively removed by a wet or dry etching process. Since the etching process employs a process with high selectivity with respect to the Si channel layer Si, the etching process may be performed precisely so as not to affect the Si channel layer Si.

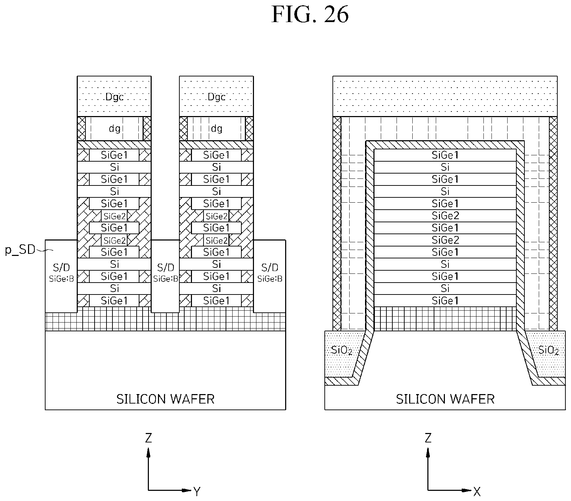

FIG. 26 is a diagram for describing a removal process of the organic solvent l_de for a semiconductor.

As shown in FIG. 26, the organic solvent l_de for a semiconductor formed on the upper portion of the lower p-MOSFET may be removed. For example, the organic solvent l_de for a semiconductor may be removed by an etch-back process.

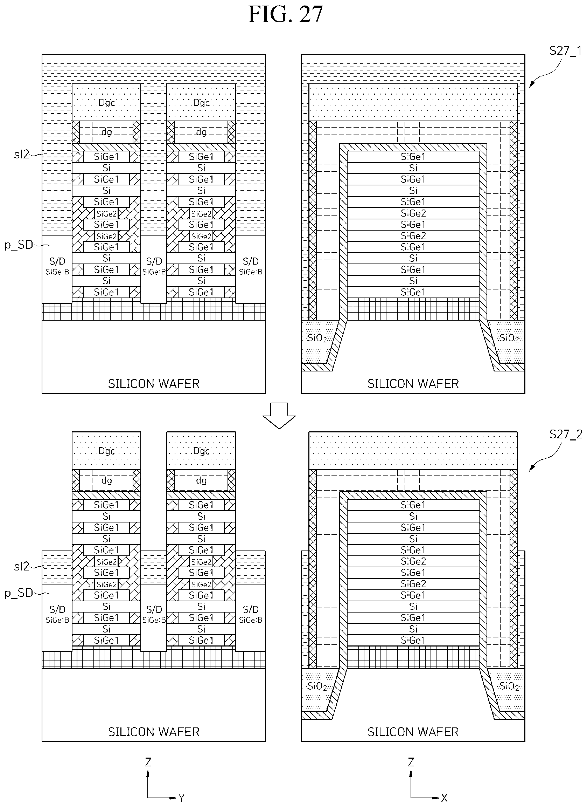

FIG. 27 is a diagram for describing an insulating process of the n-MOSFET and the P-MOSFET according to one embodiment.

Referring to FIG. 27, as in a first process (S27_1), a silicon oxide layer sl2 is formed on the entire surface (e.g., in a space where the dummy source/drain region p_S0 and the organic solvent l_de are removed) of the semiconductor substrate. Thereafter, as in a second process (S27_2), a portion of the silicon oxide layer sl2 is removed through an etch-back process. As a result, the silicon oxide layer sl2 remains only on the upper portion of the p-MOSFET, and the Si channel layer Si of the upper n-MOSFET device is completely exposed.

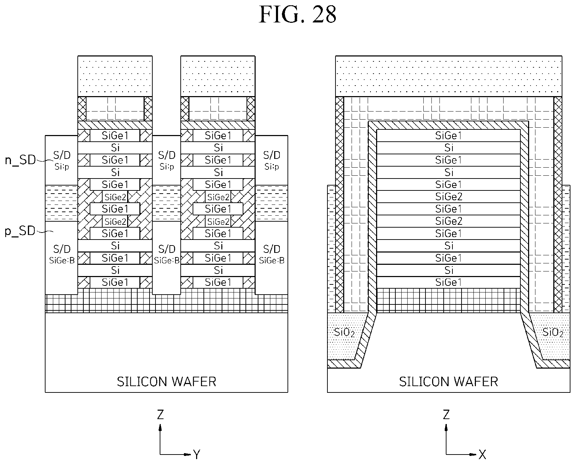

FIG. 28 is a diagram for describing a process of forming source/drain of the upper n-MOSTFET according to one embodiment.

As shown in FIG. 28, a source/drain region n_SD of the n-MOSFET is formed on the upper Si channel layer Si where silicon is exposed. For example, the Si epitaxial layer doped with an n-type dopant in real-time may be selectively grown. As another example, the source/drain region n_SD of the n-MOSFET may be formed by selectively growing the Si epitaxial layer and doping the Si epitaxial layer through an ion implantation process of an n-type dopant.

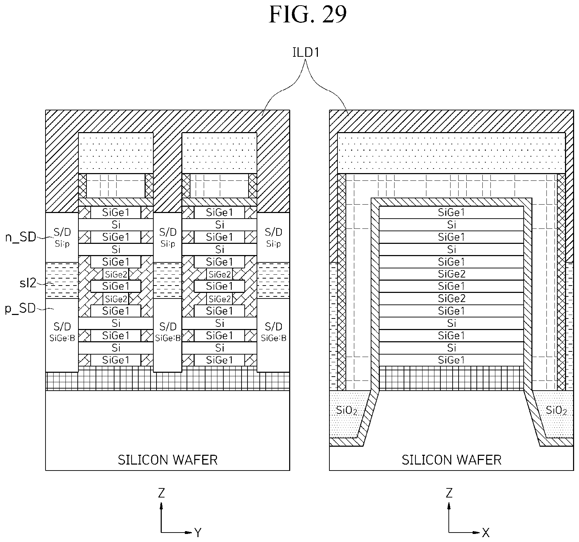

Hereinafter, a process of forming the RMG will be described with reference to FIGS. 29 to 44. This may be a process in which the dummy gate Dg is converted into an actual metal gate region.

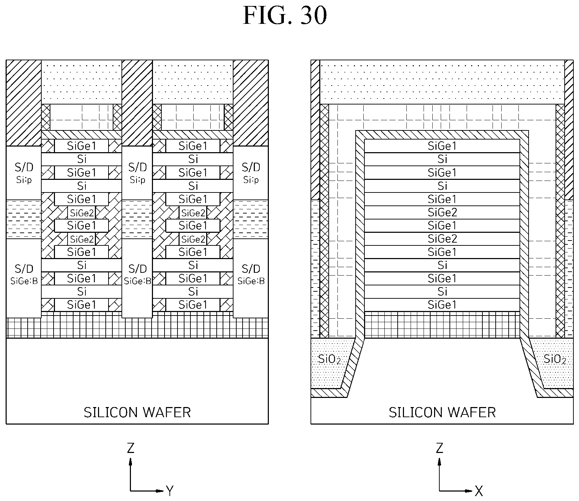

FIGS. 29 and 30 are diagrams for describing a process of forming an inter layer dielectric (ILD).

As shown in FIG. 29, an ILD that is a silicon oxide layer is formed on the entire surface (e.g., top of the upper source/drain region n_S/D and the silicon oxide layer sl2 in a thickness that covers the dummy gate cap Dgc) of the semiconductor substrate.

As shown in FIG. 30, the ILD formed on the semiconductor substrate sp is planarized through a CMP process to expose the dummy gate cap Dgc. In this case, the dummy gate cap Dgc that is the silicon nitride layer may be used as a stop layer in the planarization process. After the planarization process, the entire upper surface of the dummy gate cap Dgc may be exposed.

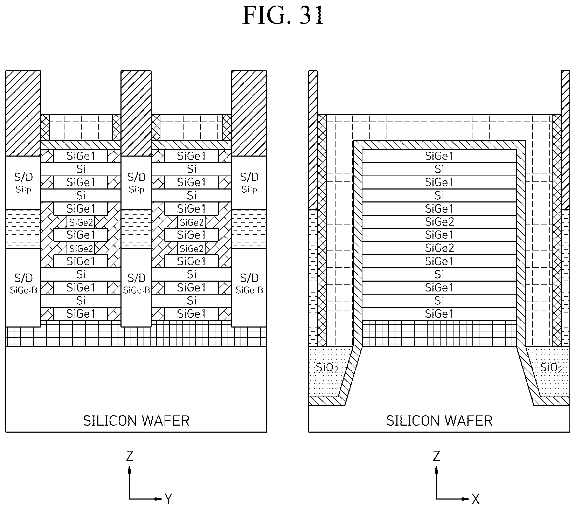

FIGS. 31, 32, and 33 are diagrams for describing a process of exposing the first and second sacrificial layers SiGe1 and SiGe2.

As shown in FIG. 31, the dummy gate cap Dgc is completely removed using a wet or dry etching process with high etch selectivity with respect to a silicon oxide layer (ILD) ILD 1.

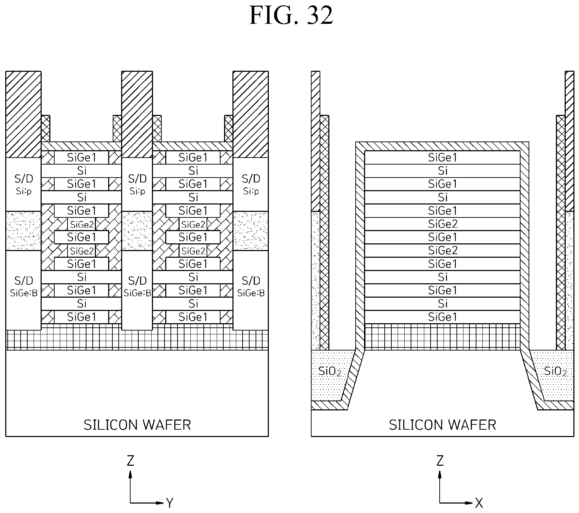

As shown in FIG. 32, the dummy gate Dg is completely removed using an etching process with high etch selectivity with respect to the silicon oxide layer and the silicon nitride layer. The silicon nitride protection layer ln2 below the dummy gate Dg completely surrounds the Si channel layer Si. Therefore, the dummy gate Dg may be removed by wet etching.

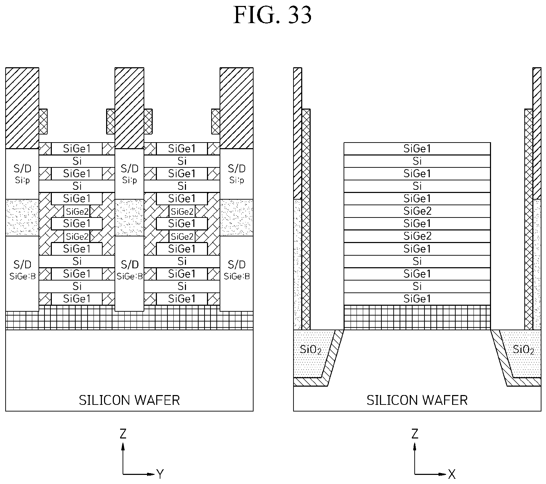

As shown in FIG. 33, the silicon nitride protection layer ln2 is removed using a specified etching process to expose the Si channel layer Si, the inner spacer is1, and the first and second sacrificial layers SiGe1 and SiGe2. The etching process of FIG. 33 may utilize an etching process with high etching selectivity with respect to the silicon oxide layer.

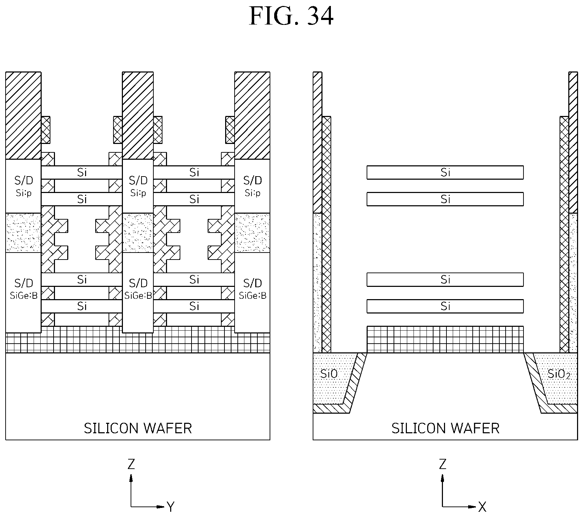

FIG. 34 is a diagram for describing a process of etching the first and second sacrificial layers SiGe1 and SiGe2.

As shown in FIG. 34, in a state in which the side surfaces of the first and second sacrificial layers SiGe1 and SiGe2 and the Si channel layer Si are exposed, the first and second sacrificial layers SiGe1 and SiGe2 are selectively etched. It is important that the etching process of the first and second sacrificial layers SiGe1 and SiGe2 has very high selectivity with respect to the ILD ILD1, the outer spacer os1, the inner spacer is1, and the Si channel layer Si. Both dry etching and wet etching are possible as selective etching of the first and second sacrificial layers SiGe1 and SiGe2. The first and second sacrificial layers SiGe1 and SiGe2 are selectively etched on both sides of a width of the silicon channel.

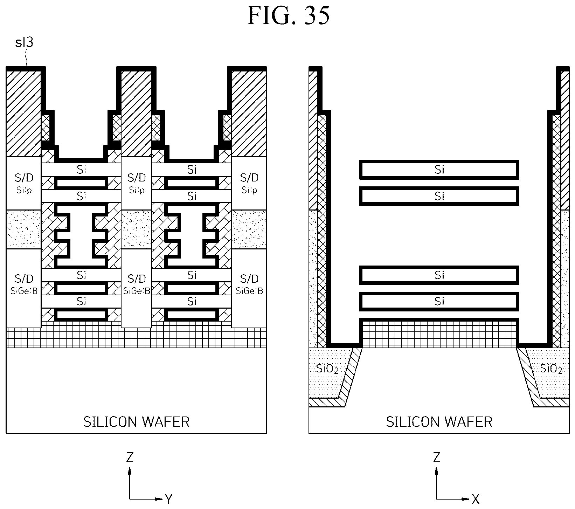

FIG. 35 is a diagram for describing a process of forming a gate dielectric insulation layer.

As shown in FIG. 35, a gate dielectric insulation layer sl3 is formed on all surfaces of the Si channel layer Si, both cross-sections of the inner spacer is1, and on a surface where the semiconductor substrate is exposed. The gate dielectric insulation layer sl3 may be formed of silicon oxide, silicon nitride, or a high-k dielectric material. The high-k dielectric material may include Hf, Zr, Al, La, Mg, Ba, Ti, or Pb or a metal oxide and silicate according to a combination of Hf, Zr, Al, La, Mg, Ba, Ti, and Pb. The gate dielectric insulation layer sl3 may be deposited with the same thickness on a three-dimensional channel using ALD.

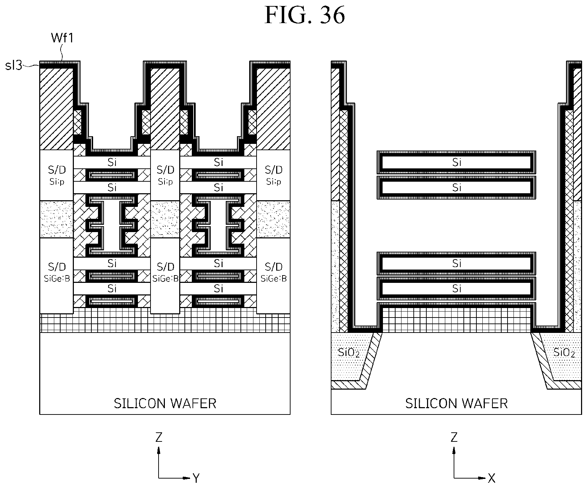

FIG. 36 is a diagram for describing a process of forming a p-type work function metal.

As shown in FIG. 36, a p-type work function metal is formed on all outer surfaces of the gate dielectric insulation layer sl3. Since the p-type work function metal Wf1 should be formed to be thin with a constant thickness, the p-type work function metal Wf1 may be formed using ALD.

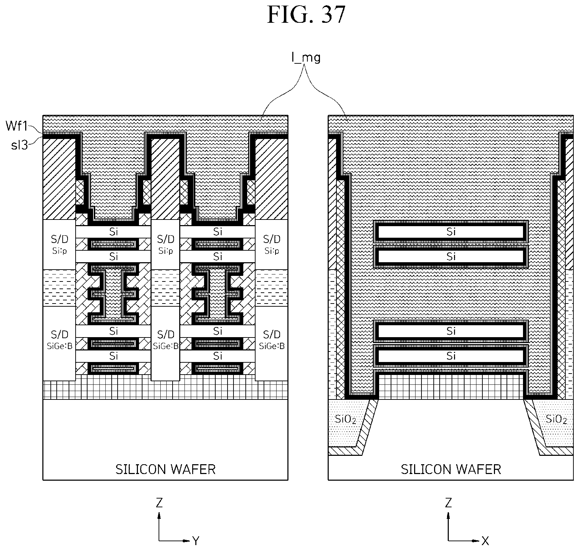

FIG. 37 is a diagram for describing a process of forming a metal gate.

As shown in FIG. 37, a portion remaining after the gate dielectric insulation layer S12 and the p-type work function metal Wf1 of the semiconductor substrate are formed is filled with a metal gate L_mg.

The metal gate L_mg may be formed in the form of at least one layer including at least one material among Ti, Al, Cu, and W. The metal gate L_mg may be formed by ALD in the same manner as the gate dielectric insulation layer sl3 and the p-type work function metal Wf1. Alternatively, the metal gate L_mg may be formed by electroplating or electroless plating.

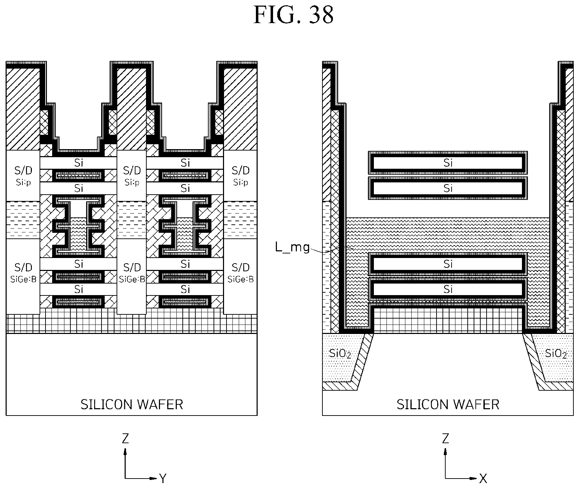

FIG. 38 is a diagram for describing an etch-back process of the metal gate.

As shown in FIG. 38, an etch-back process is performed on the metal gate L_mg. A height of the metal gate L_mg is adjusted to a height between heights of the n-MOSFET and the p-MOSFET (or, the height of the region where the p-MOSFET is formed). For the etching process of a three-dimensional complicated structure, the metal gate L_mg may be etched by wet etching.

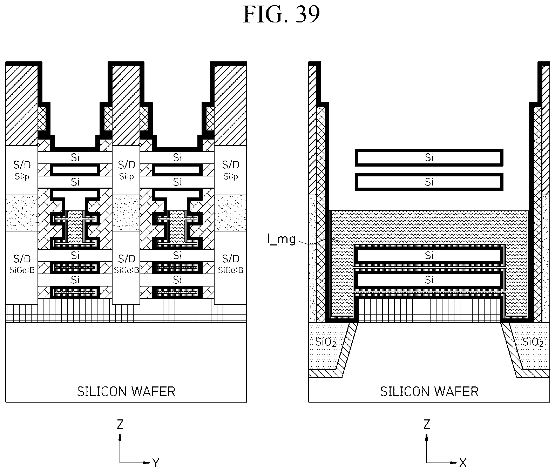

FIG. 39 is a diagram for describing a process of etching a p-type work function metal Wf1.

As shown in FIG. 39, portions of the p-type work function metal Wf1 formed around the Si channel layer of the upper n-MOSFET and formed on sidewalls may be selectively etched.

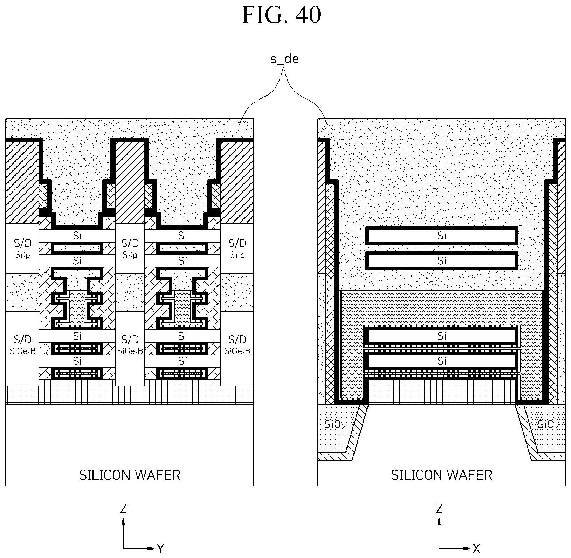

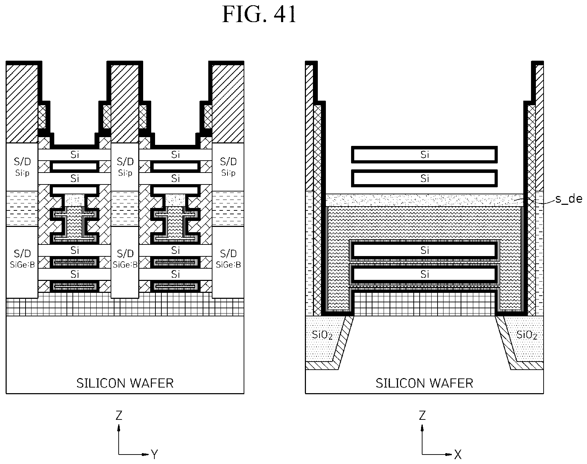

FIGS. 40 and 41 are diagram for describing a process of forming an insulator separating the n-MOSFET from the p-MOSFET.

As shown in FIG. 40, an insulator s_de is formed with a high thickness on the entire surface (e.g., on top of the metal gate L_mg) of the semiconductor substrate.

As shown in FIG. 41, the insulator s_de is removed through an etch-back process and formed only to an upper portion of the p-MOSFET metal gate.

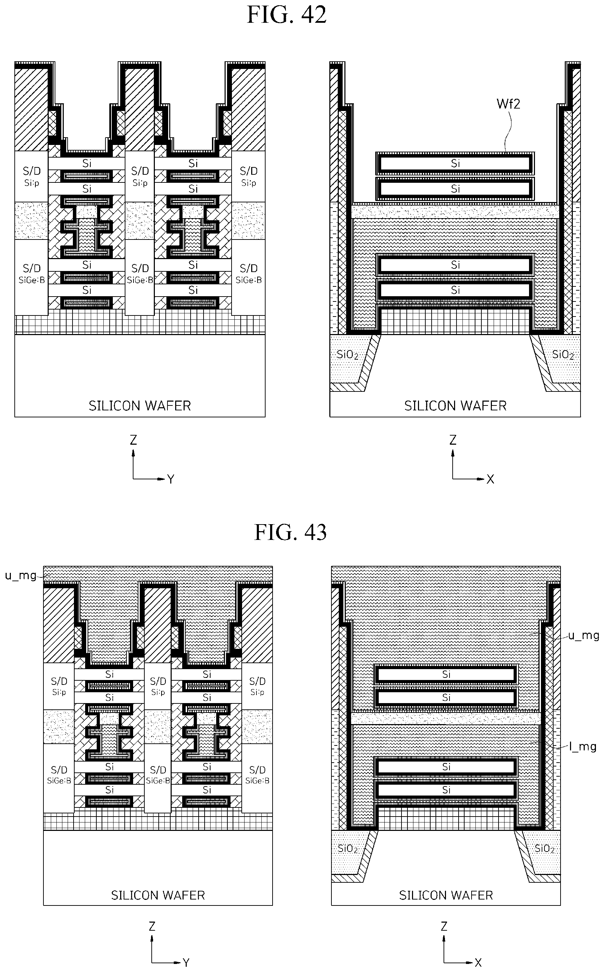

FIG. 42 is a diagram for describing a process of forming an n-type work function metal.

As shown in FIG. 42, an n-type work function metal Wf2 is formed on all surfaces of the gate dielectric insulation layer of the Si channel layer of the upper n-MOSFET. Since the n-type work function metal Wf2 should be formed to be thin with a constant thickness, the n-type work function metal Wf2 may be formed using ALD.

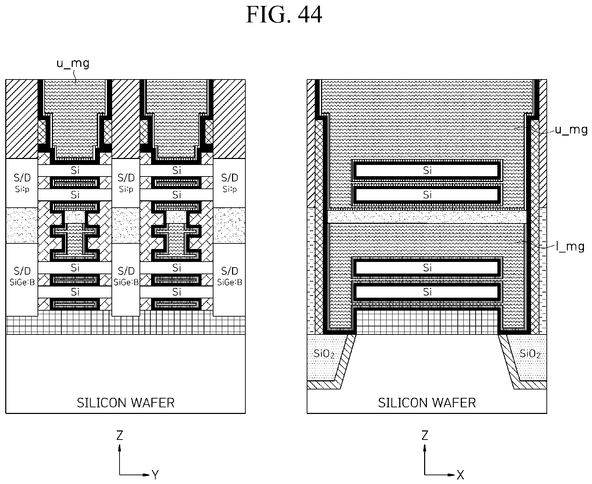

FIGS. 43 and 44 are diagrams for describing a process of forming a gate metal.

As shown in FIG. 43, a portion remaining after the gate dielectric insulation layer sl3 and the n-type work function metal are formed is filled with a metal gate u_mg. The metal gate u_mg may be formed in the form of at least one layer including at least one material among Ti, Al, Cu, and W. The metal gate u_mg may be formed by at least one of ALD, electroplating, and electroless plating.

As shown in FIG. 44, an excess portion of the gate dielectric insulation layer sl3, the n-type work function metal Wf2 and the metal gate u_mg on the upper portion of the ILD layer may be planarized using a metal CMP process.

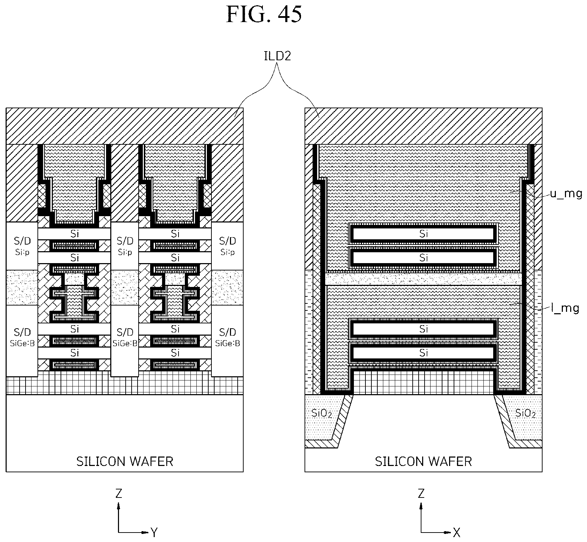

Hereinafter, a process of forming a metal line will be described with reference to FIGS. 45 to 51.

As shown in FIG. 45, a second ILD layer ILD2 is formed on the entire surface (e.g., on top of the metal gate u_mg and the gate dielectric insulation layer sl3) of the semiconductor substrate.

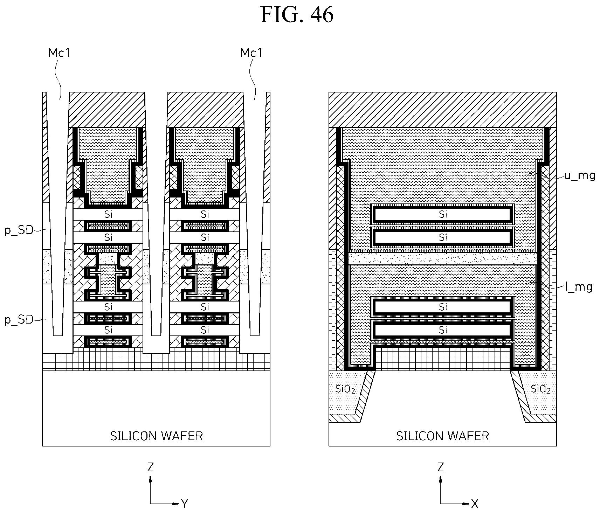

As shown in FIG. 46, a metal contact Mc1 is formed in the source/drain region (hereinafter, referred to as a "lower source/drain region") (p_SD) and the metal gate region L_mg of the lower p-MOSFET. The metal contact Mc1 may be formed through photolithography and dry etching processes for at least a portion of each of the second ILD layer ILD2, the lower source/drain region p_SD, and the lower gate region L_mg.

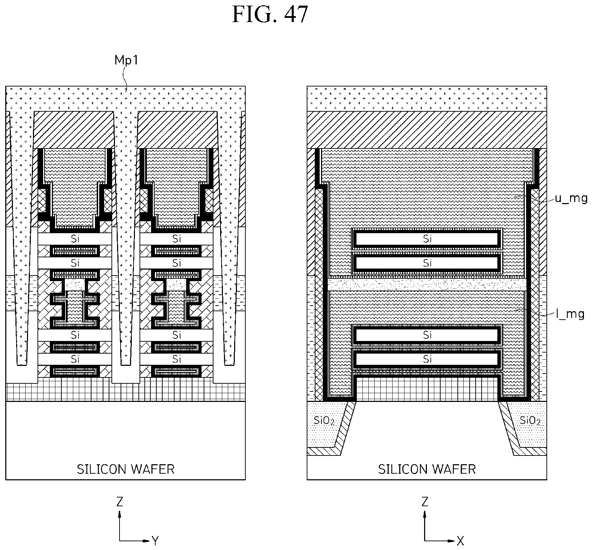

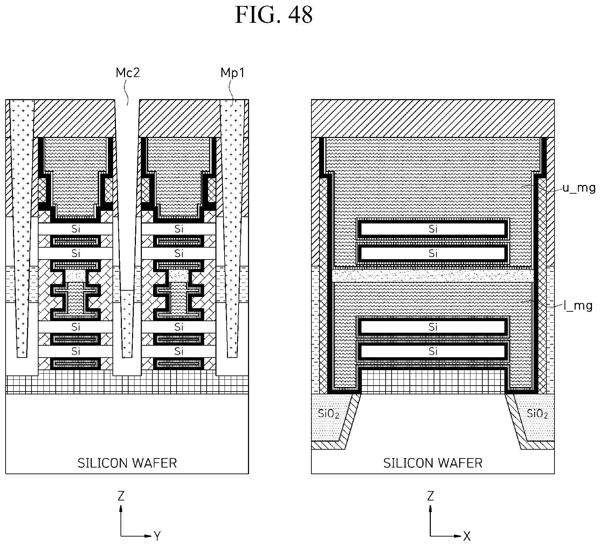

FIGS. 47 and 48 show a process of forming a metal plug.

As shown in FIG. 47, a first metal plug Mp1 is formed in the upper source/drain region p_SD and the metal contact Mc1.

As shown in FIG. 48, a portion of the first metal plug Mp1 formed on an upper portion of the second ILD layer ILD2 may be sufficiently planarized using a metal CMP process. Then, a metal wiring process for the first metal plug Mp1 is performed.

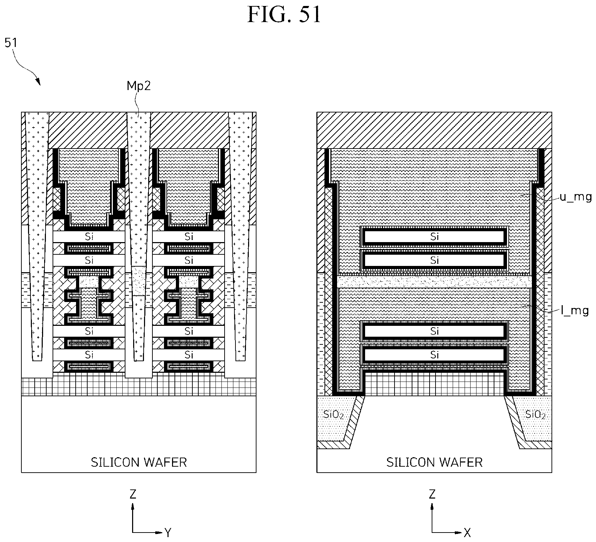

FIGS. 48 and 51 show a process of forming a second metal plug.

As shown in FIG. 48, a metal etch-back process is performed by exposing only a source/drain contact Mc2 of the first metal plug Mp1.

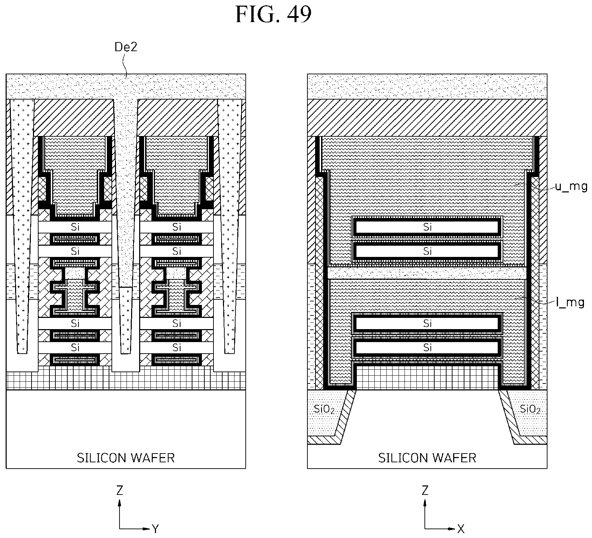

As shown in FIG. 49, an insulating layer De2 is formed on the entire surface (e.g., at least portion of the source/drain contact Mc2) of the wafer.

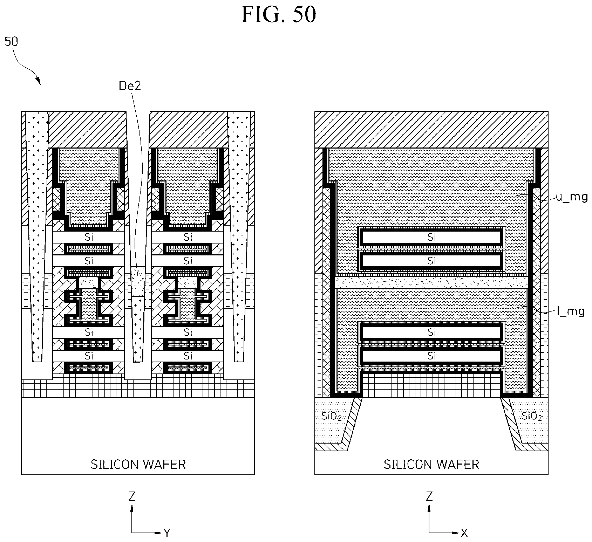

As shown in FIG. 50, an etch-back process is performed on the insulating layer De2 to expose a source/drain region of the upper n-MOSFET device.

As shown in FIG. 51, the second metal plug Mp2 may be formed in the source/drain region of the upper n-MOSFET device. Then, a metal line process may be performed on the second metal plug Mp2.

In this way, in a CFET semiconductor device 51 according to one embodiment, the source/drain regions of the n-MOSFET and the p-MOSFET may be formed through a relatively simplified process.

In addition, the CFET semiconductor device 51 according to one embodiment may be manufactured such that no void is generated when the inner spacer by stacking the SiGe sacrificial layers with different Ge contents, and the SiGe sacrificial layers are repeatedly stacked so that the gap between the n-MOSFET and the p-MOSFET may be formed sufficiently as desired.

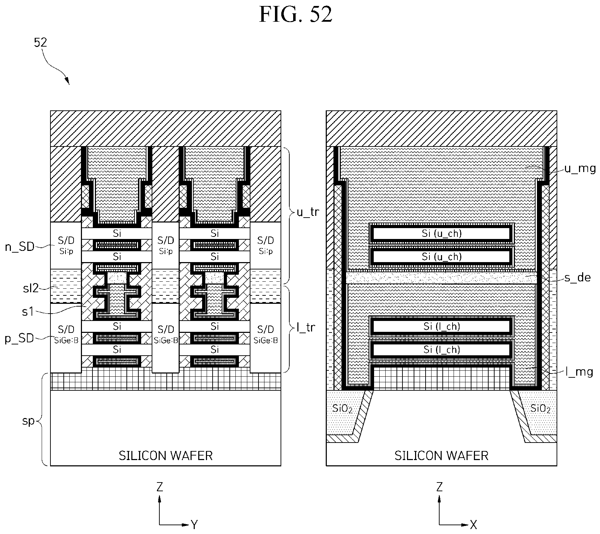

FIG. 52 is a diagram illustrating a structure of a complementary transistor device according to one embodiment.

Referring to FIG. 52, a complementary transistor device 52 according to one embodiment may include a substrate sp, a lower transistor l_tr, an upper transistor u_tr, and an inner spacer is1. In FIG. 52, an example in which the complementary transistor device 52 includes two transistors of the upper transistors u_tr and the lower transistor l_tr will be described. However, the present disclosure is not limited thereto.

The lower transistor l_tr is positioned above the substrate sp and may include a lower channel layer l_ch, a lower gate l_mg, and a lower source/drain region n_SD.

The upper transistor u_tr is positioned above the lower transistor l_tr and may include an upper channel layer u_ch, an upper gate u_mg, and an upper source/drain region p_SD.

The lower channel layer l_ch and the upper channel layer u_ch are repeatedly grown and are formed to include a first sacrificial layer SiGe1 and a second sacrificial layer SiGe2 between the lower channel layer l_ch and the upper channel layer u_ch. And then the lower channel layer l_ch and the upper channel layer u_ch may be formed to correspond to the transistors l_tr and u_tr through etching in an y direction (or x direction) corresponding to the channel length and removal of the first and second sacrificial layers SiGe1 and SiGe2.

The lower source/drain region n_SD may be formed by selectively growing a Si epitaxial layer on a sidewall of the lower channel layer on the substrate and doping the Si epitaxial layer with a first dopant (e.g., a p-type dopant).

The upper source/drain region p_SD may be formed by removing a dummy source/drain region formed on a sidewall of an upper channel layer together with the lower source/drain region in a state in which the lower source/drain region n_SD is covered with an organic solvent l_de and then removing the organic solvent l_de. The upper source/drain region p_SD may be formed by epitaxially growing the upper channel layer in a state in which a silicon oxide layer is formed only on an upper portion of the lower transistor from which the organic solvent l_de is removed.

The inner spacer is1 may be formed by removing a portion of each of the first sacrificial layer SiGe1 and the second sacrificial layer SiGe2, which are formed above and below the lower channel layer l_ch and the upper channel layer and have different Ge contents, to a depth according to the Ge content, and then depositing an insulating material. The inner spacer is1 may insulate an upper gate u_mg from the lower source/drain region n_SD and insulate the upper gate u_mg from the upper source/drain region p_SD. As a result, the inner spacer is1 may serve as a sidewall preventing a gate length (or channel length) from decreasing to a certain value or less. The inner spacer is1 may be further formed between the lower transistor l_tr and the upper transistor u_tr to separate the lower transistor l_tr from the upper transistor u_tr.

The inner spacer is1 may be positioned between the lower channel layer l_ch and the upper channel layer u_ch and configured to insulate the lower transistor l_tr from the upper transistor u_tr. Some sidewalls of the inner spacer is 1 may be formed to be thicker than sidewalls of the lower gate l_mg and the upper gate u_mg formed above and below the lower channel layer l_ch and the upper channel layer u_ch.

The first sacrificial layer SiGe1 may be a SiGe layer having a Ge content of 10% to 30%. The second sacrificial layer SiGe2 may be a SiGe layer having a Ge content that is at least 20% greater than that of the first sacrificial layer.

The inner spacer is1 may be formed by etching the second sacrificial layer SiGe2 to be deeper than the first sacrificial layer SiGe1 through cavity etching at a rate corresponding to the Ge content with high selectivity with respect to the channel layers u_ch and l_ch and depositing the insulating material on outer sides of the layers remaining after the cavity etching.

The first sacrificial layer SiGe1 may be formed on an upper portion and a lower portion of each of at least the lower channel layer l_ch and the upper channel layer u_ch, and the second sacrificial layer SiGe2 may be formed between the first sacrificial layers SiGe1 present between the at least lower channel layer l_ch and the upper channel layer u_ch.

The complementary transistor device 52 may further include a silicon oxide layer s12. The silicon oxide layer s12 may be formed between the lower source/drain region n_S/D and the upper source/drain region p_S/D to be in contact with an upper surface of the lower source/drain region n_S/D and a lower surface of the upper source/drain region p_S/D. The silicon oxide layer s12 may be configured to insulate the lower source/drain region n_S/D from the upper source/drain region p_S/D.

A first work function metal WF1 is formed between the lower channel layer l_ch and the lower gate l_mg. A second work function metal WF2 is formed between the upper channel layer u_ch and the upper gate u_mg. The first and second work functions WF1, WF2 have channel characteristics the lower gate l_mg and the upper gate u_mg, respectively.

The complementary transistor device 52 may further include an insulator s_de. The insulator s_de may insulate the lower gate l_mg from the upper gate u_mg between the lower gate l_mg and the upper gate u_mg.

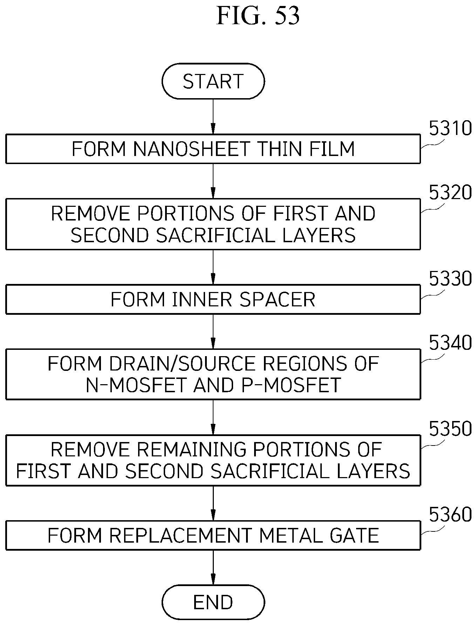

FIG. 53 is a flowchart illustrating a method of manufacturing a complementary transistor device according to one embodiment.

Referring to FIG. 53, in operation 5310, a nanosheet stack ns_s including a lower channel layer l_ch, an upper channel layer u_ch, a plurality of first and second sacrificial layers SiGe1 and SiGe2 separating the lower channel layer l_ch from the upper channel layer u_ch may be formed through epitaxial growth. The first and second sacrificial layers SiGe1 and SiGe2 may have different Ge contents.

In operation 5320, a portion of each of the first and second sacrificial layers SiGe1 and SiGe2 may be removed through an etching process at a rate according to a Ge content. For example, a portion of each of the first and second sacrificial layers SiGe1 and SiGe2 may be removed as shown in FIG. 17.

In operation 5330, an inner spacer is1 may be formed in a space where the portions of the first and second sacrificial layers SiGe1 and SiGe2 are removed. For example, the inner spacer is1 may be formed in the space where the portions of the first and second sacrificial layers SiGe1 and SiGe2 are removed as shown in FIGS. 18 and 19. In operation 5330, the inner spacer is1 may be formed as a sidewall for the remaining portions of the first and second sacrificial layers SiGe1 and SiGe2 above and below the upper channel layer u_ch and the lower channel layer l_ch.

In operation 5340, an upper drain/source region n_SD and a lower drain/source region p_SD may be formed. For example, the upper drain/source region n_SD and the lower drain/source region p_SD may be formed as shown in FIGS. 22 to 28.

In operation 5350, the remaining portions of the first and second sacrificial layers SiGe1 and SiGe2 may be removed. For example, the remaining portion of each of the first and second sacrificial layers SiGe1 and SiGe2 may be removed as shown in FIG. 34.

In operation 5360, a metal lower gate l_mg and an upper gate u_mg may be formed in the space where the first and second sacrificial layers SiGe1 and SiGe2 are removed. The lower gate l_mg may be formed around the lower channel layer l_ch, and the upper gate u_mg may be formed around the upper channel layer u_ch.

According to various embodiments disclosed in the present disclosure, an inner spacer can be formed using sacrificial layers with different Ge contents. In addition, various effects can be provided that are directly or indirectly identified through the present disclosure.

It should be understood that the various embodiments and terms used in this specification are not intended to limit the technical features described herein to specific embodiments, but rather to encompass various modifications, equivalents, or alternatives of the embodiments. In the description of the drawings, similar reference numerals may be used for similar or related components. The singular form of a noun corresponding to an item may include one or more of the items, unless the context clearly indicates otherwise. In the present specification, phrases such as "A or B," "at least one of A and B," "at least one of A or B," "A, B or C," "at least one of A, B and C," and "at least one of A, B, or C" may each include any one of the items listed together in the corresponding phrase among the above phrases or all possible combinations thereof. The terms "first," "second," "primary," and "secondary" may be merely used to distinguish a corresponding component from another corresponding component and may not limit corresponding components in another aspect (e.g., importance or an order).

The embodiments described herein will be described with reference to cross-sectional views, which are ideal schematic diagrams of the present invention. Therefore, the shape of an exemplary diagram may be modified by manufacturing techniques and/or tolerances. Accordingly, the embodiments of the present invention are not limited to specific shapes shown in the drawings, and include alternations in shape that is produced according to the manufacturing process.

It should be noted that in some alternative embodiments, functions/operations depicted in flowchart blocks of the present specification may be performed out of the order depicted in the flowchart. For example, two blocks shown in succession may in fact be executed substantially simultaneously. Alternatively, blocks may sometimes be executed in a reverse order according to involved functions/actions. In addition, a function of a given block of the flowchart and/or block diagram may be separated into a plurality of blocks, and/or functions of two or more blocks of the flowchart and/or block diagram may be at least partially integrated. In addition, other blocks may be added/inserted between the shown blocks, and/or blocks/operations may be omitted without departing from the scope of the technical spirit of the present invention.

Unless defined otherwise, all terms (including technical and scientific terms) used herein may be used in a sense commonly understood by those skilled in the art to which the present invention pertains. Terms defined in commonly used dictionaries are to be understood as not being ideally or excessively interpreted unless explicitly and specifically defined otherwise.

Terms used herein are for the purpose of describing the embodiments and are not intended to limit the present specification. In the present specification, the singular form includes the plural form unless specifically stated otherwise in the context. In the present application, the terms "comprising," "having," or the like are used to specify that a feature, a number, a step, an operation, a component, an element, or a combination thereof described herein exists, and they do not preclude the presence or addition of one or more other features, numbers, steps, operations, components, elements, or combinations thereof.

When a component is referred to as being "coupled," "connected," or "responsive," or "on" other component, it may be directly coupled, connected, responsive, or on the other component, or the other component may intervene therebetween. On the other hand, when a component is "directly coupled," "directly connected," "directly responsive," or "directly on" other component, no other component may intervene therebetween. In the present specification, the term "and/or" includes one or more or all combinations of the related enumerated items. In addition, a symbol "/" (e.g., when used in the term "source/drain") will be understood to be identical to the term "and/or."

The terms "first," "second," and the like may be used to describe various components, but the components are not limited by these terms. These terms are used only to distinguish one component from another component. For example, without departing from the scope of the present invention, a "first component" may be referred to as a "second component."

As shown in the drawings, spatially relative terms "below," "beneath," "lower," "above," "on," "upper," and the like can be used to easily describe a correlation between one element or components and another element or components. In addition to a direction shown in the drawings, the spatially relative terms should be understood as terms including different directions of components when the components are used or operated. For example, when an element shown in the drawing is inverted, the element described as being "below or beneath" another element may be disposed "above" another element. Consequently, the exemplary term "below" can include all of downward and upward directions. The element may also be oriented in other directions (e.g., rotated 90 degrees or in other directions), in this case, spatially relative terms may be interpreted according to the orientation.

In the present specification, many different embodiments are disclosed in conjunction with the drawings and the above-described description. It should be understood that it may be excessively repetitive and confusing to fully describe and illustrate all combinations and sub-combinations of these embodiments. Therefore, it should be construed that the detailed description including the drawings is intended to be a complete description of all the combinations and sub-combinations of the embodiments described herein and of the methods and processes for manufacturing and using them, and is intended to support claims relating to such combinations or sub-combinations.

The inventions disclosed above are considered as embodiments and therefore should not be construed as limiting, and the appended claims should be understood to include modifications, additions, and other embodiments according to the spirit of the present invention. Accordingly, the scope of protection of the present invention should be determined to the maximum extent permitted by the law by the fullest interpretation of the following claims and their equivalents, and should not be limited by the detailed description.

## Claims

1. A transistor device comprising:
a substrate;
a lower transistor positioned on the substrate and including a lower channel layer, a lower gate, and a lower source/drain region;
an upper transistor positioned on the lower transistor and including an upper channel layer, an upper gate, and an upper source/drain region; and
an inner spacer positioned between the lower channel layer and the upper channel layer, and configured to insulate the lower transistor from the upper transistor,
wherein some sidewalls of the inner spacer are formed to be thicker than sidewalls of the lower gate and the upper gate formed above and below the lower channel layer and the upper channel layer.

2. The transistor device of claim 1, wherein the inner spacer is formed by removing a portion of each of a first sacrificial layer and a second sacrificial layer, which are formed above and below the lower channel layer and the upper channel layer and have different Ge contents each other, to a depth according to a Ge content and then depositing an insulating material.

3. The transistor device of claim 2, wherein the inner spacer is formed by etching the second sacrificial layer to be deeper than the first sacrificial layer through cavity etching at a rate corresponding to the Ge content with high selectivity with respect to the channel layers and depositing the insulating material on outer sides of the layers remaining after the cavity etching.

4. The transistor device of claim 2 or 3, wherein:
the first sacrificial layer is formed upper and lower portions of each of at least the lower channel layer and the upper channel layer; and
the second sacrificial layer is formed between the first sacrificial layers between the at least lower channel layer and the upper channel layer.

5. The transistor device of one of claims 2 to 4, wherein:
the inner spacer is formed to be in contact with at least some side surfaces of each of the first sacrificial layer and the second sacrificial layer between the lower channel layer and the upper channel layer; and
the lower gate and the upper gate are formed around the lower channel layer and the upper channel layer of a space remaining by removing the first sacrificial layer and the second sacrificial layer.

6. The transistor device of one of claims 1 to 5, further comprising a silicon oxide layer (s12) formed between the lower source/drain region and the upper source/drain region to be in contact with an upper surface of the lower source/drain region and a lower surface of the upper source/drain region and configured to insulate the lower source/drain region from the upper source/drain region.

7. The transistor device of one of claims 1 to 6, wherein:
a first work function metal is formed between the lower channel layer and the lower gate;
a second work function metal is formed between the upper channel layer and the upper gate; and
the first and second work functions have channel characteristics the lower gate and the upper gate, respectively.

8. The transistor device of claim 7, further comprising an insulator (s_de) configured to insulate the lower gate from the upper gate between the lower gate and the upper gate.

9. A method of manufacturing a transistor device, comprising:
forming a nanosheet stack including a lower channel layer, an upper channel layer, and at least one of a first sacrificial layers and a plurality of second sacrificial layers separating the lower channel layer from the upper channel layer, wherein the first and second sacrificial layers have different Ge contents;
forming an inner spacer in a space provided by removing a portion of the first sacrificial layers and a portion of the second sacrificial layers through an etching process at a rate according to a Ge content; and
forming a lower gate around the lower channel layer and an upper gate around the upper channel layer in a provided space from which a remaining portion of each of the first and second sacrificial layers is removed.

10. The method of claim 9, wherein the forming of the inner spacer includes:
forming the nanosheet stack such that the first sacrificial layers are included between the lower channel layer and the upper channel layer and the plurality of second sacrificial layers are included between the first sacrificial layers;
etching a portion of each of the first and second sacrificial layers at an etching rate according to the Ge content, wherein a sidewall of the plurality of second sacrificial layers are etched to be deeper than sidewalls of the first sacrificial layers; and
forming the inner spacer by depositing an insulating material on the sidewalls of each of the first and second sacrificial layers.

11. The method of claim 9 or 10, further comprising, after the forming of the inner spacer and before the forming of the gates, forming a lower source/drain region on a sidewall of the lower channel layer using a substrate below the lower channel layer.

12. The method of claim 11, further comprising:
covering the lower source/drain region with an organic solvent, removing a dummy source/drain region in a state in which the dummy source/drain region formed on a sidewall of the upper channel layer is exposed together with the lower source/drain region, and then removing the organic solvent;
forming a silicon oxide layer on an outer surface of the nanosheet stack from which the organic solvent is removed; and
forming an upper source/drain region on the sidewall of the upper channel layer on the silicon oxide layer.

13. The method of one of claims 9 to 12, further comprising:
forming a dummy gate on an outer side of the nanosheet stack; and
forming an outer spacer by depositing a silicon oxide layer on a side surface of the dummy gate through a thermal oxidation process,
wherein the outer spacer forms sidewalls of the dummy gate and the space from which the remaining portion of the first and second sacrificial layers is removed.

14. The method of claim 13, further comprising:
forming a dummy gate cap on the dummy gate; and
etching the dummy gate, the upper channel layer, and the lower channel layer according to a specified channel length using the dummy gate cap as a hard mask.

15. A transistor device comprising:
a substrate;
a lower transistor positioned on the substrate and including a lower channel layer, a lower gate, and a lower source/drain region; and
an upper transistor positioned on the lower transistor and including an upper channel layer, an upper gate, and an upper source/drain region,
wherein an upper end portion of the lower gate and, an insulator (s_de), and a lower end portion of the upper gate, and
when viewed from one side of the transistor device, a width of at least one among the upper end portion of the lower gate and, the insulator (s_de), and the lower end portion of the upper gate is formed to be thinner than the remaining widths of the lower gate and the upper gate, which are formed below the lower channel layer and above the upper channel layer, respectively.
